# EUROPEAN PATENT APPLICATION

(11) **EP 4 672 014 A2**
(43) Date of publication of application: **31.12.2025**
(21) Application number: 24781178.9
(22) Date of filing: 26.03.2024
(51) Int. Cl.: G06F 16/11, G06F 16/16, G06F 16/18, G06F 16/25

(54) **SYSTEM OF CONVERTING BINARY FILE GENERATED IN BATTERY CYCLER TO TEXT FILE, AND METHOD THEREOF**

(30) Priority: 30.03.2023 KR 20230042349
(71) Applicant: LG Energy Solution, Ltd., Seoul 07335 (KR)
(72) Inventor: YEOM, In-Cheol, Daejeon 34122 (KR)
(74) Representative: Plasseraud IP
(86) International application number: PCT/KR2024/003758
(87) International publication number: WO 2024/205187

(57) **Abstract**

Disclosed is a system and method of converting a binary file generated by a battery cycler into a text file. The system includes a database server in which a database including a first table containing a cycler ID and version information of a binary file generated by a cycler and a second table containing the cycler ID and data structure information of the binary file generated by the cycler is built; a data server configured to receive a binary file containing a test result of a battery from the cycler and store the binary file in a first storage medium; and a computer connected to the database server and the data server and including a second storage medium and a processor. The processor may determine a cycler ID which generated a conversion target binary file from the first table using file version information read from a header of the conversion target binary file as a query key, and convert the conversion target binary file into a text file based on the data structure information read from the second table using the cycler ID as a query key and record the text file in the second storage medium.

## Description

### TECHNICAL FIELD

The present disclosure relates to a system and method of converting a binary file, and more specifically, to a system and method of converting a binary file generated by a battery cycler into a text file.

The present application claims priority to Korean Patent Application No. 10-2023-0042349 filed on March 30, 2023 in the Republic of Korea, the disclosures of which are incorporated herein by reference.

### BACKGROUND ART

Recently, as the demand for portable electronic products such as laptops, video cameras, and portable phones has rapidly increased and the development of electric vehicles, energy storage batteries, robots, and satellites has begun, the research for high-performance batteries capable of repeated charging and discharging is being actively performed.

A battery cycler (hereinafter, abbreviated as a 'cycler') is a device that tests the performance of a battery. The cycler is used in research, manufacturing, and quality control fields to determine the performance and characteristics of batteries.

The cycler may repeatedly charge and discharge the battery (i.e. perform cycling) while varying the operating conditions of the battery, such as battery temperature, charging rate, and discharging rate.

The cycler may measure the SOC, capacity, resistance, and other performance factors of the battery while cycling the battery. Also, the cycler may be used to evaluate new materials and structural designs to optimize performance and lifespan of the battery.

Cyclers are classified into cell-level cyclers and pack-level cyclers. Here, the pack is a large-capacity battery including a plurality of cells connected in series and/or parallel. The pack is a large-capacity battery used in electric vehicles, power tools, and power storage devices.

The cycler has a plurality of test channels that may independently control tests on the battery. Therefore, the cycler may test a plurality of cells or packs corresponding to the number of test channels.

The cycler performs a cycling test on a plurality of cells or packs in a plurality of test channels, then generates a binary file for each channel, and records the set of binary files on a storage medium. The storage medium may be provided in the cycler itself, or, if the cycler is connected to the network, the storage medium may be a storage medium of a data server included in the network.

Even if the binary file is generated from the same type of cycler, the binary file may have different data structures depending on the manufacturing period of the cycler or the requirements of the cycler purchaser. The cycler contains information about the data structure of the binary file and provides application software that may convert the binary file into a text file.

However, because the data structure of the binary file may be different for each cycler, there is no guarantee that a binary file generated in one cycler can be converted into a text file in the application software of another cycler.

To check the test results of the battery, the tester may download the binary file generated in the cycler from the cycler or from a data server of the network to a personal computer.

In order for the tester to check the test results of the battery on a personal computer, the binary file must be converted into a text file. For file conversion, the tester must accurately identify the cycler in which the binary file is generated, install the application software provided by the manufacturer of the cycler on the personal computer, and directly convert the binary file into a text file using the application software.

The series of file conversion works causes inefficiency in the analysis of test results. In particular, when a plurality of cyclers that generate binary files with different data structures are operated, the inefficiency involved in file conversion works for a plurality of binary files may be further aggravated.

### DISCLOSURE

### Technical Problem

The present disclosure is designed to solve the problems of the related art, and therefore the present disclosure is directed to providing a system and method that may build data structure information of binary files generated in a plurality of cyclers into a table-based relational database and automating the conversion work for binary files into text files using the database.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

In one aspect of the present disclosure, there is provided a system of converting a binary file generated in a battery cycler into a text file, comprising: a database server in which a database including a first table containing a cycler ID and version information of a binary file generated by a cycler and a second table containing the cycler ID and data structure information of the binary file generated by the cycler is built; a data server configured to receive a binary file containing a test result of a battery from the cycler and store the binary file in a first storage medium; and a computer connected to the database server and the data server and including a second storage medium and a processor.

The processor may be configured to determine a cycler ID which generated a conversion target binary file from the first table using file version information read from a header of the conversion target binary file as a query key, and convert the conversion target binary file into a text file based on the data structure information read from the second table using the cycler ID as a query key and record the text file in the second storage medium.

The processor may be configured to output a binary file list on a display by searching the first storage medium, and allow at least one conversion target binary file to be selected from a tester.

The cycler may include a plurality of test channels, each performing a test independently, and may be configured to generate at least two binary files with different versions for each test channel, and the first table may have a data structure in which one cycler ID and at least two version information match each other.

The second table may be built independently for each of the at least two binary files with different versions.

The second table may have a data structure in which information about type, name, and size of each of a plurality of data included in the data structure information is matched with a corresponding cycler ID each other.

The test result may include first to n^{th} operation characteristic data regarding battery operation characteristics obtained periodically, and the binary file may include a header structure containing the version information and first to n^{th} data structures in a binary data format corresponding to the first to n^{th} operation characteristic data, respectively.

The processor may be configured to sequentially generate first to n^{th} operation characteristic data in a text data format while sequentially reading the first to n^{th} data structures from the conversion target binary file with reference to the data structure information of the conversion target binary file retrieved from the second table and generate a text file containing the first to n^{th} operation characteristic data in the text data format.

The text file may have an 'xls' extension, a 'cvs' extension or a 'txt' extension.

A k^{th} data structure (k is a natural number from 1 to n) may include time data corresponding to an acquisition time of k^{th} operation characteristic data and a plurality of operation characteristic data selected from voltage data and current data of the battery, temperature data of a constant temperature chamber in the cycler, and SOC change amount data, and each of the time data and the plurality of operation characteristic data may be included in the k^{th} data structure with a preset data size.

The processor may be configured to transmit the text file to the data server through the network, and the data server may be configured to store the text file in the first storage medium to be matched with the conversion target binary file.

The processor may be configured to determine a conversion rate of the conversion target binary file to the text file in real time and output the rate in a graphic user interface through a display.

The processor may be configured to analyze the first to n^{th} operation characteristic data in the text data format included in the text file to generate a time change pattern of the operation characteristic data selected from the voltage data and current data of the battery, the temperature data of the constant temperature chamber in the cycler, and the SOC change amount data as a graph image and output the graph image through a display.

In another aspect of the present disclosure, there is also provided a method of converting a binary file generated in a battery cycler into a text file, comprising: (a) by a database server, building a database including a first table containing a cycler ID and version information of a binary file generated by a cycler and a second table containing the cycler ID and data structure information of the binary file generated by the cycler; (b) by a data server, receiving a binary file containing a test result of a battery from the cycler through a network and storing the binary file in a first storage medium; (c) by a computer, outputting a binary file list on a display by searching the first storage medium, and allowing at least one conversion target binary file to be selected from a tester; (d) by the computer, identifying file version information included in a header of the conversion target binary file; (e) by the computer, determining a cycler ID which generated the conversion target binary file from the first table using the file version information as a query key in association with the database server; (f) by the computer, reading data structure information of the conversion target binary file from the second table using the cycler ID as a query key in association with the database server; and (g) by the computer, converting the conversion target binary file into a text file based on the data structure information and recording the text file in a second storage medium.

In the step (a), the database server may build the second table independently for each version of the binary file.

In the step (g), the computer may sequentially generate first to n^{th} operation characteristic data in a text data format while sequentially reading the first to n^{th} data structures from the conversion target binary file with reference to the data structure information of the conversion target binary file retrieved from the second table, and generate a text file containing the first to n^{th} operation characteristic data in the text data format.

The method according to the present disclosure may further comprise the step of, by the computer, transmitting the text file to the data server; and by the data server, storing the text file in the first storage medium to be matched with the corresponding conversion target binary file.

The method according to the present disclosure may further comprise the step of, by the computer, determining a conversion rate of the conversion target binary file to the text file in real time and outputting the rate in a graphic user interface through the display.

The method according to the present disclosure may further comprise the step of, by the computer, analyzing the first to n^{th} operation characteristic data in the text data format included in the text file to generate a time change pattern of the operation characteristic data selected from the voltage data and current data of the battery, the temperature data of the constant temperature chamber in the cycler, and the SOC change amount data as a graph image and outputting the graph image through the display.

### Advantageous Effects

According to an embodiment of the present disclosure, the binary files generated by a plurality of cyclers may be stored comprehensively in a data server, a table-based relational database may be built using the data structure information of the binary files generated by each cycler based on the version of the binary file, and the conversion work for the binary file into a text file may be performed automatically using the database. As a result, the time required to convert the binary file generated by the cycler into a text file may be shortened. In particular, in the present disclosure, it is possible to dramatically reduce the hassle of the file conversion work when performing mass cycling tests for the battery by operating a plurality of cyclers.

The effects of the present disclosure are not limited to the above-mentioned effects, and these and other effects not mentioned herein will be clearly understood by those skilled in the art from the appended claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a block diagram schematically showing the configuration of a system that converts a binary file generated in a battery cycler into a text file according to an embodiment of the present disclosure.
FIG. 2 is a diagram exemplarily showing a data structure of a first table included in a database according to an embodiment of the present disclosure.
FIG. 3 is a diagram exemplarily showing a data structure of a second table included in the database according to an embodiment of the present disclosure.
FIG. 4 is a diagram exemplarily showing another second table containing data structure information of a binary file with a different version when the corresponding binary file is additionally generated according to an embodiment of the present disclosure.
FIG. 5 is a diagram conceptually showing the structure of two binary files 'TEST#1_file1.bin' and 'TEST#1_file2.bin' generated in a #1 test channel of a cycler with a cycler ID of '1' according to an embodiment of the present disclosure.
FIG. 6 is a diagram conceptually showing the structure of two binary files 'TEST#4_file1.bin' and 'TEST#4_file2.bin' generated in a #4 test channel of the cycler with a cycler ID of '2' according to another embodiment of the present disclosure.
FIG. 7 is a flowchart for illustrating a method for converting a binary file generated in a battery cycler into a text file according to an embodiment of the present disclosure.
FIG. 8 is a diagram exemplarily showing a graphic user interface that displays a conversion rate of a binary file according to an embodiment of the present disclosure.
FIG. 9 is a diagram exemplarily showing a graph image of battery operation characteristic data generated by analyzing the text file converted according to an embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, are used to distinguish one element from another among various elements, but not intended to limit the elements by the terms.

Throughout the specification, when a part is said to "include" a certain element, this means that it does not exclude other elements, but may further include other elements, unless specifically stated to the contrary.

Throughout the specification, it will be further understood that when an element is referred to as being "connected to" another element, it can be directly connected to the other element or intervening elements may be present.

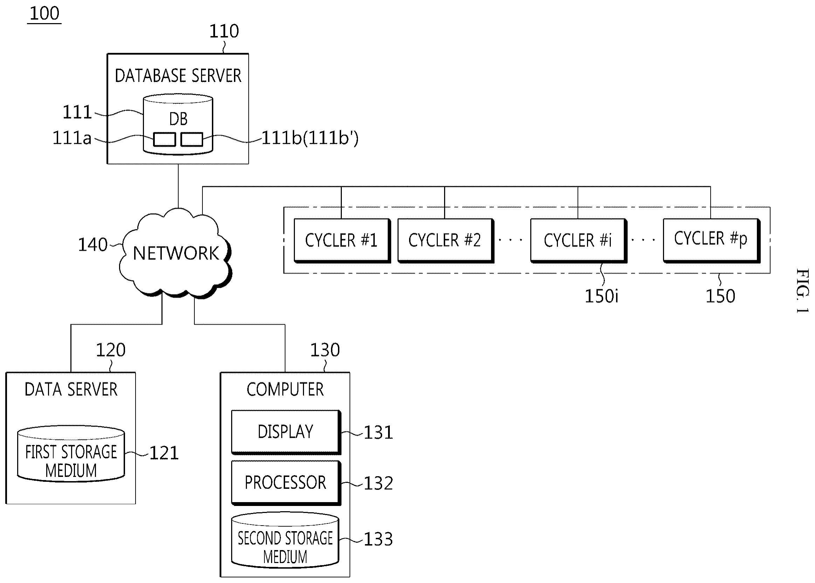

FIG. 1 is a block diagram schematically showing the configuration of a system 100 that converts a binary file generated in a battery cycler into a text file according to an embodiment of the present disclosure.

Referring to FIG. 1, the system 100 according to an embodiment of the present disclosure may include a database server 110, a data server 120, and a computer 130.

In an embodiment, the database server 110, the data server 120, and the computer 130 may be connected to each other to enable mutual communication through a network 140.

There is no limit to the type of the network 140 as long as it supports communication between the database server 110, the data server 120, and the computer 130.

The network 140 includes a wired network, a wireless network, or a combination thereof. A wired network includes a local area or wide area Internet that supports the TCP/IP protocol. A wireless network includes a base station-based wireless communication network, a satellite communication network, a short-range wireless communication network such as Wi-Fi, or a combination thereof.

The network 140 may include, for example, a 2G (second generation) to 5G (fifth generation) network, a LTE (Long Term Evolution) network, a GSM (Global System for Mobile communication) network, a CDMA (Code Division Multiple Accesses) network, an EVDO (Evolution-Data Optimization) network, a PLM (Public Land Mobile) network, and/or other networks.

As another example, the network 140 may include LAN (Local Area Network), WLAN (Wireless Local Area Network), WAN (Wide Area Network), MAN (Metropolitan Network), PSTN (Public Switched Telephone Network), an ad hoc network, a managed IP network, VPN (Virtual Private Network), intranet, Internet, a fiber-optic network, and/or a combination of these, or other types of networks.

According to another aspect, a plurality of cyclers 150 may be connected to the data server 120 through the network 140 to enable mutual communication with the data server 120.

At least one of the plurality of cyclers 150 may be a cell cycler capable of testing a cell-level battery. Also, at least one of the plurality of cyclers 150 may be a pack cycler capable of testing a pack-level battery.

Any cycler 150i (i is a natural number from 1 to p) may have one or at least two test channels. The test channel may have a constant temperature chamber in which a cell-level or pack-level battery is loaded. The test channel has sensors that may obtain voltage data and current data of the battery and temperature data of the constant temperature chamber, a power regulation circuit that may variably control charging current, charging voltage, discharging current, and discharging voltage of the battery according to cycling conditions, and a controller that comprehensively controls the cycler. The cycler 150i may be appropriately selected from products commercialized in the art.

The cycler 150i may independently perform a cycling test in each test channel for batteries loaded in a plurality of test channels. While performing a cycling test in one test channel, the cycler 150i may periodically obtain battery operation characteristic data including at least one of the voltage data and current data of the battery, the temperature data of the constant temperature chamber, and the SOC change amount data of the battery using the sensors.

If the battery is one cell, the voltage data of the battery may include a cell voltage and, optionally, a cell average voltage for a predetermined time. If the battery is a pack including a plurality of cells, the voltage data of the battery includes a pack voltage and voltages of cells included in the pack and, optionally, a pack average voltage for a predetermined time and a cell average voltage of each of the cells included in the pack.

If the battery is one cell, the current data of the battery may include a cell current and, optionally, a cell average current for a predetermined time. If the battery is a pack including a plurality of cells, the current data of the battery may include a pack current, and optionally, a pack average current for a predetermined time. In the present disclosure, the current may be charging current or discharging current flowing through a cell or pack.

The temperature data of the constant temperature chamber may include temperature of the constant temperature chamber in which the battery is loaded and, optionally, an average temperature of the constant temperature chamber for a predetermined time.

The controller of the cycler 150i may periodically determine a SOC change amount of the battery for a predetermined time using the current data of the battery. In addition, the cycler 150i may generate a binary file containing the plurality of battery operation characteristic data obtained as a test result in the test channel and the version information of the file and record the binary file on a storage medium provided therein. Hereinafter, for convenience of explanation, the plurality of battery operation characteristic data will be referred to as first to n^{th} operation characteristic data.

The cycler 150i may generate one or at least two binary files in one test channel. If there are a plurality of binary files, the binary files may have different file versions. If a plurality of binary files are generated in one test channel, the acquisition periods of the first to n^{th} operation characteristic data included in each binary file may be different.

In one example, the cycler 150i may obtain battery operation characteristic data containing at least one of the voltage data (average voltage of a cell or pack) and the current data (average current of a cell or pack) of the battery, the temperature data (average temperature) of the constant temperature chamber, and the SOC change amount at every first time period (e.g., 10 seconds) while cycling the battery, generate a first binary file containing first to n^{th} operation characteristic data obtained at a plurality of time points and version information of the file, and record the first binary file on the storage medium.

In addition, the cycler 150i may obtain battery operation characteristic data containing at least one of the voltage data (voltage of a cell or pack) and the current data (current of a cell or pack) of the battery, the temperature data of the constant temperature chamber, and the SOC change amount at every second time period (e.g., 1 second) while cycling the battery, generate a second binary file containing first to n^{th} operation characteristic data obtained at a plurality of time points and version information of the file, and record the second binary file on the storage medium.

Since the first time period and the second time period are different, the number of battery operation characteristic data included in the first binary file and the second binary file may be different. Therefore, the index n, which represents the number of battery operation characteristic data, may be different for each binary file.

In the present disclosure, the number of binary files generated through one test channel is not particularly limited. Therefore, the number of binary files may increase to three or more depending on the conditions for obtaining battery operation characteristic data.

According to another aspect, the binary file may include a header structure containing the version information of the file and first to n^{th} data structures in a binary data format corresponding to the first to n^{th} operation characteristic data, respectively.

Any k^{th} data structure (k is a natural number from 1 to n) may include a plurality of operation characteristic data selected from time data corresponding to the acquisition time of the k^{th} operation characteristic data, the voltage data and the current data of the battery, the temperature data of the constant temperature chamber, and the SOC change amount data, and each of the time data and the plurality of operation characteristic data may have a preset data size and be included in the k^{th} data structure.

In an embodiment, the database server 110 may have a database 111 that includes a first table 111a containing the cycler ID and the version information of the binary file generated by the cycler, and a second table 111b containing the cycler ID and the data structure information of the binary file generated by the cycler.

Preferably, the database 111 may be a relational database that stores data using a table structure with rows and columns. The relational database is well known in the art, and thus will not be described in detail here.

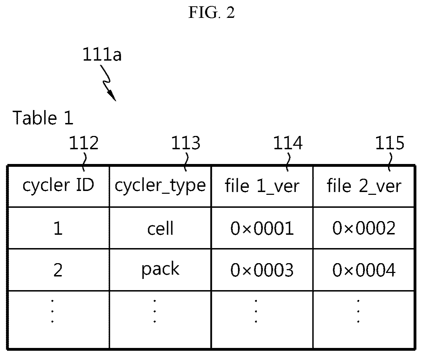

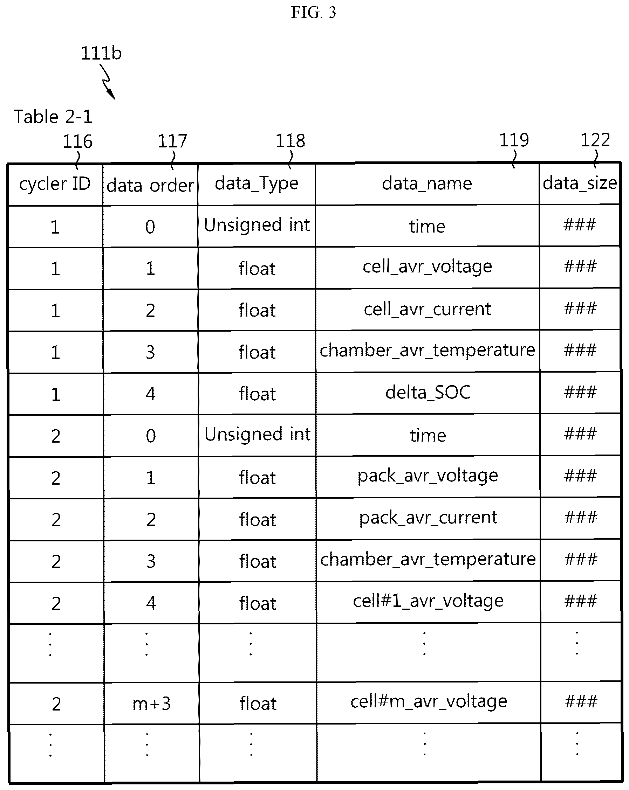

FIG. 2 is a diagram exemplarily showing a data structure of the first table 111a according to an embodiment of the present disclosure, and FIG. 3 is a diagram exemplarily showing a data structure of the second table 111b according to an embodiment of the present disclosure.

Referring to FIG. 2, the first table 111a may include a data field 112 in which the cycler ID is recorded; and at least one data field 114, 115 in which the version information of the binary file generated by the cycler is recorded. The cycler includes a plurality of test channels that may perform a cycling test independently, and may be configured to generate at least two binary files with different versions in the cycling test of each test channel. In the data field 114, 115 in which the version information of the binary file is recorded, the version information of each binary file generated by the cycler may be recorded for each cycler ID.

Hereinafter, for convenience of explanation, the version information of the binary file recorded in the data field 114 will be referred to as first version information, and the version information of the binary file recorded in the data field 115 will be referred to as second version information.

If the number of binary files generated by a cycler assigned with a specific ID is three or more, a data field in which the version information of the binary file is recorded may be further added. The version information recorded in the added data field may be named third version information, fourth version information, etc.

The first table 111a may, optionally, further include a data field 113 in which the type of cycler is recorded. In the data field 113 in which the type of cycler is recorded, a flag indicating cell or pack may be recorded.

Referring to FIG. 3, the second table 111b may have a data structure in which information on the type, name, and size of each of the plurality of data included in the data structure is matched with a corresponding cycler ID each other.

Specifically, the second table 111b may include a data field 116 in which the cycler ID is recorded, and a plurality of fields 117, 118, 119, 122 in which the data structure information of the binary file generated by the cycler is recorded.

In the second table 111b, the field in which the data structure information is recorded may include a field 117 in which the arrangement order of data within the data structure is recorded; a field 118 in which the type of the data is recorded; a field 119 in which the name of the data is recorded; and a field 122 in which the size of the data is recorded.

The second table 111b illustrated in FIG. 3 may be a table containing the data structure information of the first binary file described above, and in the first table 111a illustrated in FIG. 2, the data field 114 in the third column may be a field defined to record the version information of the first binary file.

As shown in FIGS. 2 and 3, the cycler with a cycler ID of '1' may perform a cycling test on a cell, and the data structure of the first binary file generated by the cycler may sequentially include time data for the time at which battery operation characteristic data is obtained; data on the cell average voltage (cell_avr_voltage) during a predetermined period as one of the battery operation characteristic data; data on the cell average current (cell_avr_current) during a predetermined period as another of the battery operation characteristic data; data on the average temperature (chamber_avr_temperature) of the constant temperature chamber during a predetermined period as still another of the battery operation characteristic data; and data on the SOC change amount (delta_SOC) during a predetermined period as still another of the battery operation characteristic data.

In a specific example, the plurality of data structures included in the first binary file generated by the cycler with a cycler ID of '1' may include the plurality of battery operation characteristic data about the cell respectively obtained at 10 second intervals. Each battery operation characteristic data may include a time corresponding to the acquisition time point of the battery operation characteristic data; a cell average voltage for 10 seconds; a cell average current for 10 seconds; an average temperature of the constant temperature chamber for 10 seconds; and a SOC change amount for 10 seconds.

In addition, as shown in FIGS. 2 and 3, the cycler with a cycler ID of '2' may perform a cycling test on the pack, and the data structure of the first binary file generated by the corresponding cycler may sequentially include time data for the time at which the battery operation characteristic data is obtained; data on the pack average voltage (pack_avr_voltage) during a predetermined period as one of the battery operation characteristic data; data on the pack average current (pack_avr_current) during a predetermined period as another type of the battery operation characteristic data; data on the average temperature (chamber_avr_temperature) of the constant temperature chamber during a predetermined period as still another of the battery operation characteristic data; and data on the average voltage of each cell included in the pack (cell#1_avr_voltage, ..., cell#m_avr_voltage; m is the total number of cells) as still another of the battery operation characteristic data.

In a specific example, the plurality of data structures included in the first binary file generated by the cycler with a cycler ID of '2' may include the plurality of battery operation characteristic data on the pack respectively obtained at 10 second intervals. Each battery operation characteristic data may include a time corresponding to the acquisition time point of the battery operation characteristic data; a pack average voltage for 10 seconds; a pack average current for 10 seconds; an average temperature of the constant temperature chamber for 10 seconds; and an cell average voltage for 10 seconds for each of the cells included in the pack.

Meanwhile, when the cycler additionally generates a binary file with a different version, a second table containing data structure information of the corresponding binary file may be additionally generated.

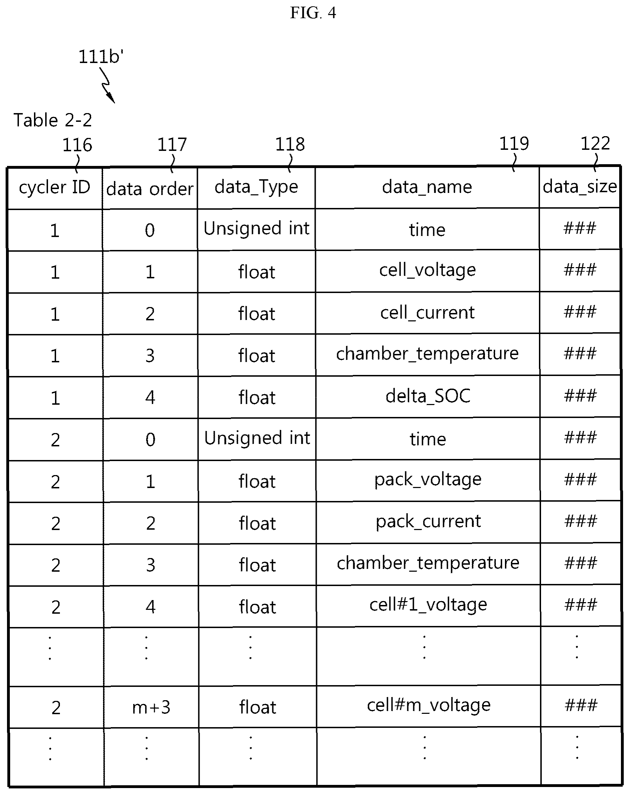

FIG. 4 is a diagram exemplarily showing another second table 111b' containing data structure information of a binary file with a different version when the corresponding binary file is additionally generated in the same cycling test according to an embodiment of the present disclosure.

The second table 111b' illustrated in FIG. 4 may be a table containing the data structure information of the second binary file described above, and in the first table 111a illustrated in FIG. 2, the data field 115 in the fourth column may be a field defined to record the version information of the second binary file.

As shown in FIGS. 2 and 4, the cycler with a cycler ID of '1' may perform a cycling test on the cell, and the data structure of the second binary file generated by the cycler may sequentially include time data for the time at which the battery operation characteristic data is obtained; data on the cell voltage (cell_voltage) obtained at the corresponding time as one of the battery operation characteristic data; data on the cell current (cell_current) obtained at the corresponding time as another type of the battery operation characteristic data; data on the temperature of the constant temperature chamber (chamber_temperature) obtained at the corresponding time as still another of the battery operation characteristic data; and data on the SOC change amount (delta_SOC) during a predetermined period as still another of the battery operation characteristic data.

In a specific example, the plurality of data structures included in the second binary file generated by the cycler with a cycler ID of '1' may include the plurality of battery operation characteristic data for the cell respectively obtained at 1 second intervals. Each battery operation characteristic data may include a time corresponding to the acquisition time point of the battery operation characteristic data; a cell voltage obtained at the corresponding time; a cell current obtained at the corresponding time; a temperature of the constant temperature chamber obtained at the corresponding time; and a SOC change amount for 1 second.

In addition, as shown in FIGS. 2 and 4, the cycler with a cycler ID of '2' may perform a cycling test on the pack, and the data structure of the second binary file generated by the cycler may sequentially include time data for the time at which the battery operation characteristic data is obtained; data on the pack voltage (pack_voltage) obtained at the corresponding time as one of the battery operation characteristic data; data on the pack current (pack_current) obtained at the corresponding time as another of the battery operation characteristic data; data on the temperature of the constant temperature chamber (chamber_temperature) obtained at the corresponding time as still another of the battery operation characteristic data; and data on the voltage of each cell included in the pack (cell#1_voltage, ..., cell#m_voltage; m is the total number of cells) as still another of the battery operation characteristic data.

In a specific example, the plurality of data structures included in the second binary file generated by the cycler with a cycler ID of '2' may include the plurality of battery operation characteristic data on the pack respectively obtained at 1 second intervals. Each battery operation characteristic data may include a time corresponding to the acquisition time point of the battery operation characteristic data; a pack voltage obtained at the corresponding time; a pack current obtained at the corresponding time; a temperature of the constant temperature chamber obtained at the corresponding time; and a cell voltage of each of the cells included in the pack obtained at the corresponding time.

Referring to FIG. 1 again, the data server 120 may receive a binary file containing first to n^{th} operation characteristic data respectively in the first to n^{th} data structures as a test result of the battery from the plurality of cyclers 150 through the network 140 and store the binary file in the first storage medium 121.

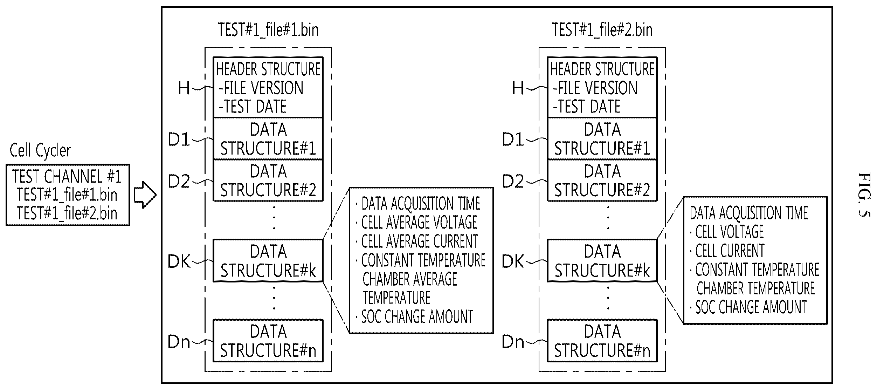

FIG. 5 is a diagram conceptually showing the structure of two binary files 'TEST#1_file1.bin' and 'TEST#1_file2.bin' generated in the #1 test channel of the cycler with a cycler ID of '1' according to an embodiment of the present disclosure. In the strings included in the name of the binary file, 'TEST#1' indicates that the corresponding binary file is a binary file generated through a cycling test of the #1 test channel of the cycler.

Referring to FIG. 5, the binary files 'TEST#1_file1.bin' and 'TEST#1_file2.bin' may commonly include a header structure H and a plurality of data structures D1 to Dn. n represents the number of data structures and may vary depending on the version of the binary file.

The header structure H may include version information of the binary file and, optionally, information on the date at which the cycling test is performed.

Any k^{th} data structure Dk (k is a natural number from 1 to n) may sequentially include data corresponding to the data structure information stored in the second table 111b, 111b'.

In a specific example, any k^{th} data structure Dk (k is a natural number from 1 to n) included in the binary file 'TEST#1_file1.bin' may sequentially include the battery operation characteristic data acquisition time; the cell average voltage for a predetermined time; the cell average current for a predetermined time; the average temperature of the constant temperature chamber for a predetermined time; and the SOC change amount for a predetermined time to correspond to the data structure information recorded in the second table 111b.

In addition, any k^{th} data structure Dk (k is a natural number from 1 to n) included in the binary file 'TEST#1_file2.bin' may sequentially include the battery operation characteristic data acquisition time; the cell voltage obtained at the corresponding time; the cell current obtained at the corresponding time; the constant temperature chamber temperature obtained at the corresponding time; and the SOC change amount during a predetermined time to correspond to the data structure information recorded in the second table 111b'.

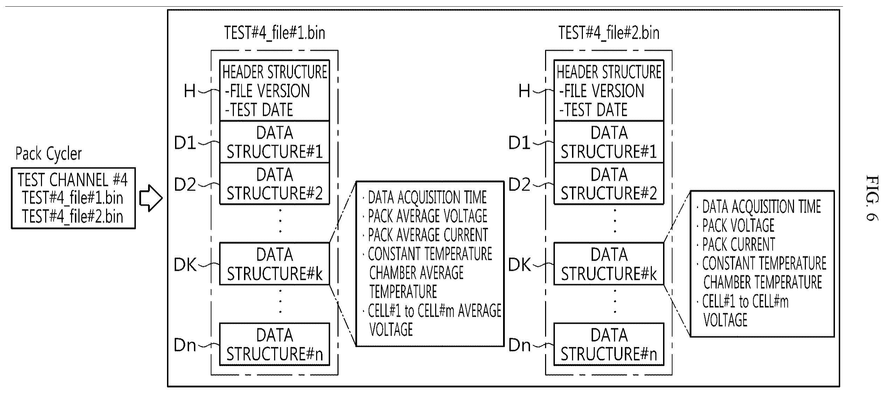

FIG. 6 is a diagram conceptually showing the structure of two binary files 'TEST#4_file1.bin' and 'TEST#4_file2.bin' generated in the #4 test channel of the cycler with a cycler ID of '2' according to another embodiment of the present disclosure. In the strings included in the name of the binary file, 'TEST#4' indicates that the corresponding binary file is a binary file generated through a cycling test of the #4 test channel.

Referring to FIG. 6, the binary files 'TEST#4_file1.bin' and 'TEST#4_file2.bin' may commonly include a header structure H and a plurality of data structures D1 to Dn. n represents the number of data structures and may vary depending on the version of the binary file.

The header structure H may include version information of the binary file and, optionally, information on the date at which the cycling test is performed.

Any k^{th} data structure Dk (k is a natural number from 1 to n) may include data corresponding to the data structure information stored in the second table 111b, 111b'.

In a specific example, any k^{th} data structure Dk (k is a natural number from 1 to n) included in the binary file 'TEST#4_file1.bin' may sequentially include the battery operation characteristic data acquisition time; the pack average voltage for a predetermined time; the pack average current for a predetermined time; the average temperature of the constant temperature chamber for a predetermined time; and the cell average voltage of each of the cells included in the pack for a predetermined time to correspond to the data structure information recorded in the second table 111b.

In addition, any k^{th} data structure Dk (k is a natural number from 1 to n) included in the binary file 'TEST#4_file2.bin' may sequentially include the battery operation characteristic data acquisition time; the pack voltage obtained at the corresponding time; the pack current obtained at the corresponding time; the temperature of the constant temperature chamber obtained at the corresponding time; and the cell voltage of each of the cells included in the pack to correspond to the data structure information recorded in the second table 111b'.

Referring to FIG. 1 again, the computer 130 may be connected to the database server 110 and the data server 120 through the network 140. The computer 130 may also include a display 131, a processor 132, and a second storage medium 133. The computer 130 may also include an input device (not shown) known in the art such as a keyboard and/or mouse.

According to the embodiment, the processor 132 may output a list of binary files stored in the first storage medium 121 through the display 131 of the computer 130 by searching for the first storage medium 121 in association with the data server 120 at the request of the tester. The processor 132 may also be configured to execute a control logic that selects at least one conversion target binary file to be converted into a text file from the tester.

In another aspect, the processor 132 may be configured to execute a control logic that downloads the selected conversion target binary file(s) from the data server 120 through the network 140 and records the selected conversion target binary file(s) in the second storage medium 133.

In still another aspect, the processor 132 may be configured to execute a control logic that reads the file version information from the header structure of the conversion target binary file(s).

In still another aspect, the processor 132 may be configured to execute a control logic that determines a cycler ID that has generated the conversion target binary file(s) from the first table 111a of the database 111 using the file version information read from the conversion target binary file(s) as a query key, in association with the database server 110 through the network 140.

In a specific example, if the version information of the file read from the two conversion target binary files selected by the tester is '0x0001' and '0x0002', the processor 132 may identify that the cycler ID which generated the two binary files is '1' by searching the first table 111a of the database 111 using the version information of the file as a query key.

In still another aspect, the processor 132 may be configured to execute a control logic that reads data structure information corresponding to the version information of the conversion target binary file from the second table 111b, 111b' of the database 111 using the cycler ID as a query key, converts the conversion target binary file(s) into a text file based on the data structure information, and records the text file in the second storage medium 133 of the computer 130, in association with the database server 110 through the network 140.

If the second table 111b, 111b' is built as an independent table for each version of the binary file, the processor 132 may identify the table corresponding to the version information of the conversion target binary file and read the data structure information corresponding to the conversion target binary file from the identified table using the cycler ID as a query key.

In a specific example, if the second table 111b shown in FIG. 3 is defined as including data structure information of a binary file with first version information (0x0001, 0x0003) recorded in the third data field 114 of the first table 111a and the second table 111b' shown in FIG. 4 is defined as including data structure information of a binary file with second version information (0x0002, 0x0004) recorded in the fourth data field 115 of the first table 111a, the processor 132 may read the data structure information of the conversion target binary file with the version information of '0x0001' from the second table 111b in FIG. 3 using the cycler ID '1' as a query key and read the data structure information of the conversion target binary file having the version information of '0x0002' from the second table 111b' in FIG. 4 using the cycler ID '1' as a query key.

In another aspect, the processor 132 may be configured to sequentially generate first to n^{th} operation characteristic data in the text data format while sequentially reading the first to n^{th} data structures from the conversion target binary file with reference to the data structure information of the conversion target binary file retrieved from the second table 111b, 111b', generate a text file containing the first to n^{th} operation characteristic data in the text data format, and store the text file in the second storage medium 133 of the computer 130.

In another aspect, the text file generated by the processor 132 may have an 'xls' extension, a 'cvs' extension, or a 'txt' extension. Here, the 'xls' extension is a file extension of Microsoft's Excel software.

In a specific example, if the text file is a file with an 'xls' extension, the processor 132 may generate a table, which has rows corresponding to the number obtained by adding 1 to the total number of data structures contained in the conversion target binary file and columns corresponding to the number of data contained in each data structure, in the file, sequentially record the name of data included in each data structure in each column of the first row of the table, and sequentially record the data included in the battery operation characteristic data in a text format read from each data structure in each column of the second to last rows of the table.

In another specific example, if the text file is a file with a 'cvs' extension or a 'txt' extension, the processor 132 may generate empty paragraphs, a number of which corresponds to the number obtained by adding 1 to the total number of data structures contained in the conversion target binary file, in the file, sequentially record the names of data included in each data structure in the first paragraph with delimiters (e.g., tab symbol, colon symbol, semicolon symbol, etc.) interposed therebetween, and sequentially record the data included in the battery operation characteristic data in a text format read from each data structure in the second to last paragraphs with delimiters interposed therebetween.

According to another aspect, the processor 132 may transmit the converted text file to the data server 120 through the network 140. Then, the data server 120 may be configured to store the text file in the first storage medium 121 to be matched with the corresponding conversion target binary file. In one example, the processor 132 may store the text file together in a directory where the conversion target binary file is stored.

According to still another aspect, the processor 132 may be configured to execute a control logic that determines the conversion rate in real time while converting the conversion target binary file into a text file and outputs the rate in a graphic user interface through the display 131. Preferably, the graphic user interface may be configured to display the conversion rate as a number (%).

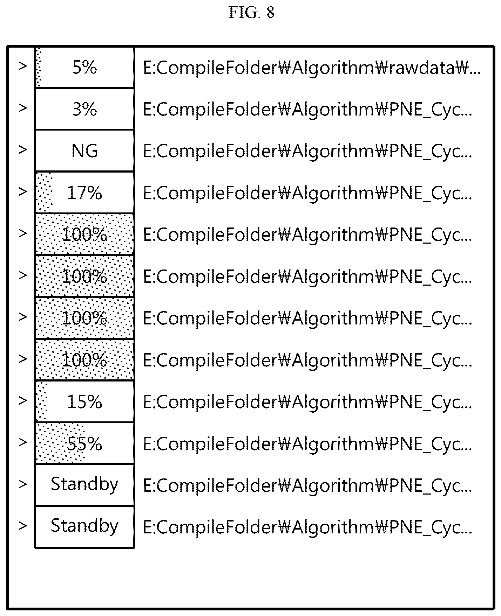

FIG. 8 is a diagram exemplarily showing a graphic user interface that displays the rate according to an embodiment of the present disclosure. As shown in FIG. 8, the graphic user interface may comprehensively display the conversion rate of a plurality of conversion target binary files.

According to still another aspect, the processor 132 may be configured to execute a control logic that generates a change pattern for at least one operation characteristic data selected from the voltage data and current data of the battery, the temperature data of the constant temperature chamber, and the SOC as a graph image by analyzing the first to n^{th} operation characteristic data in a text format included in the text file at the request of the tester and outputs the change pattern through the display 131.

In one example, if the tester designates the cycler ID as '1', designates the test channel as '#4', and designates the operation characteristic data to generate a graph image as cell voltage data of the battery, the computer 130 may identify the text file converted from the binary file generated in the '#4' test channel with the cycler ID of '1' by searching the second storage medium 133, parse n time data and voltage data from the first to n^{th} operation characteristic data included in the text file, generate the voltage data change of the battery as a graph image based on the parsed information, and visually output the generated graph image through the display 133 of the computer 130. The parsed voltage data may be cell voltage or cell average voltage depending on the version of the binary file. If there are two or more versions of the binary file, the computer 130 may allow additional versions of the binary file to be further designated from the tester.

Preferably, the computer 130 may allow a cycler ID, at least one test channel, and the type of operation characteristic data for generating a graph image to be designated from the tester, generate at least one graph image according to the designated conditions, and display the graph image through the display 131 of the computer 130.

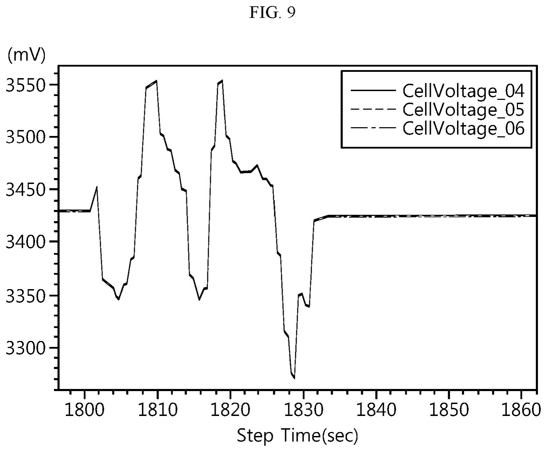

FIG. 9 is a diagram exemplarily showing a graph image according to an embodiment of the present disclosure. As shown in FIG. 9, the tester may easily visually check the voltage change pattern of three cells by designating three channels (#4, #5, #6) for a specific cycler.

The processor 132 of the computer 130 is a control circuit and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors and electrical units for performing the other functions.

The processor 132 of the computer 130 may include a plurality of cores. In this case, the processor 132 may distribute and process the text file conversion task for a plurality of binary files in parallel using the plurality of cores. In this case, data processing speed and efficiency may be increased. Parallel distributed task processing may be especially useful when there are a large number of binary files to be converted into text files.

The storage medium 121, 133 may be at least one type of storage medium selected from flash memory type, hard disk type, SSD (Solid State Disk) type, Silicon Disk Drive (SDD) type, multimedia card micro type, random access memory (RAM), static random access memory (SRAM), read-only memory (ROM), electrically erasable programmable read-only memory (EEPROM) and programmable read-only memory (PROM).

In the present disclosure, the computer 130 may optionally include a processor, an application-specific integrated circuit (ASIC), other chipsets, logic circuits, registers, communication modems, data processing devices, etc. known in the art to execute the various control logics described above.

Also, when the control logics are implemented as program, the processor 132 of the computer may execute the program. At this time, the program may be stored in a memory and executed by the processor 132. The memory may be provided inside or outside the processor, and may be connected to the processor by various well-known computer components. Also, the memory may be included in the second storage medium 133. Also, the memory generically refers to a device that stores information regardless of the type of device, and does not refer to a specific memory device.

In addition, one or more of various control logics executed by the processor 132 of the computer 130 are combined, and the combined control logics may be written in a computer-readable code system and recorded on a computer-readable storage medium. The type of the storage medium is not particularly limited as long as it can be accessed by the processor included in the computer. As an example, the storage medium includes at least one selected from the group including a ROM, a RAM, a register, a CD-ROM, a magnetic tape, a hard disk, a floppy disk, and an optical data recording device. In addition, the code system may be distributively stored and executed in computers connected through a network. In addition, functional programs, codes and code segments for implementing the combined control logics may be easily inferred by programmers in the art to which the present disclosure belongs.

Next, a method for converting a binary file generated in a battery cycler into a text file according to an embodiment of the present disclosure will be described in detail.

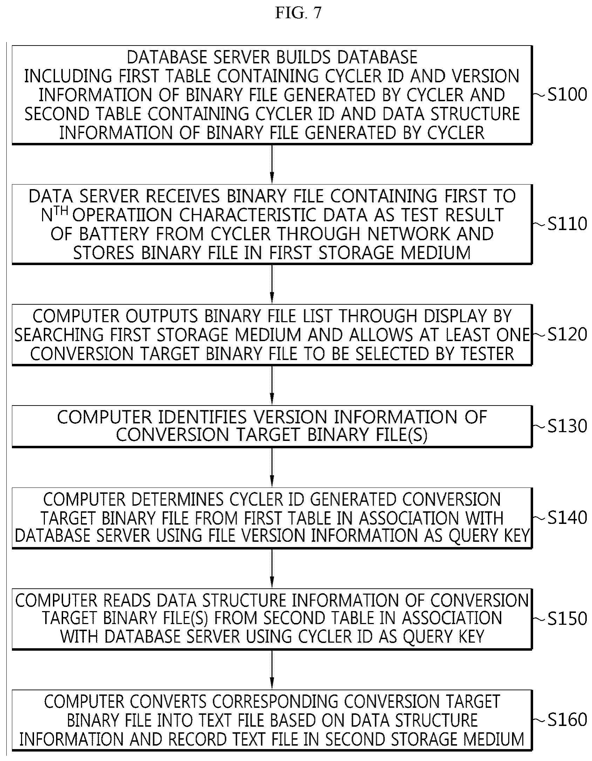

FIG. 7 is a flowchart for illustrating a method for converting a binary file generated in a battery cycler into a text file according to an embodiment of the present disclosure.

In the following description, the steps performed by the computer 130 are steps performed by the processor 132 of the computer 130.

Referring to FIGS. 1 and 7 together, first, in Step S100, the database server 110 may build a database 111 including a first table 111a containing a cycler ID and version information of a binary file generated by the cycler, and a second table 111b, 111b' containing the cycler ID and data structure information of the binary file generated by the cycler.

The first table 111a may have a data structure in which one cycler ID and version information of at least two binary files match each other. For this purpose, the first table 111a may include a data field in which the cycler ID is recorded and at least two data fields in which version information for at least two binary files is recorded, respectively (see FIG. 2).

If the first table 111a has a data field in which version information for at least two binary files is recorded, the database server 110 may independently build a second table for each version of the binary file (see FIGS. 3 and 4).

The second table 111b, 111b' may have a data structure in which information about the type, name, and size of each of the plurality of data included in the data structure is matched with a corresponding cycler ID each other.

In Step S110, the data server 120 may receive a binary file containing the test result of the battery from the cycler 150i through the network 140 and store the binary file in the first storage medium 121.

In the present disclosure, the cycler 150i includes a plurality of test channels that enable independent testing on a plurality of batteries, and may generate a binary file with at least two different versions for each test channel and transmit the binary file to the data server 120 through the network 140.

The test result of the battery may include first to n^{th} operation characteristic data. Any k^{th} operation characteristic data (k is a natural number from 1 to n) may include a plurality of operation characteristic data selected from the voltage data and current data of the battery, the temperature data of the constant temperature chamber, and the SOC change amount data of the battery obtained in the k^{th} period. The first to n^{th} operation characteristic data may be recorded in a binary data format in the first to n^{th} data structures within each binary file.

Step S120 proceeds after Step S110.

In Step S120, the computer 130 may output a list of binary file(s) through the display 131 by searching the first storage medium 121 in association with the data server 120 through the network 140 at the request of the tester, and allow at least one conversion target binary file(s) to be selected from the tester.

The computer 130 may output a graphic user interface including the names and generation dates of the binary files through the display 131 for easy selection of the conversion target binary file(s).

In Step S130, the computer 130 may also identify version information of the conversion target binary file(s). The computer 130 may parse the header structure of the conversion target binary file(s) to identify the version information of the file.

In Step S140, the computer 130 may also determine the cycler ID that has generated the conversion target binary file from the first table 111a of the database 111 in association with the database server 110 through the network 140 using the file version information as a query key.

In Step S150, the computer 130 may also read the data structure information of the conversion target binary file(s) from the second table 111b, 111b' of the database 111 in association with the database server 110 through the network 140 using the cycler ID as a query key.

In Step S160, the computer 130 may also convert the conversion target binary file(s) into a text file based on the read data structure information and record the text file in the second storage medium 133.

Specifically, the computer 130 may sequentially generate first to n^{th} operation characteristic data in the text data format while sequentially reading the first to n^{th} data structures from the conversion target binary file with reference to the data structure information of the conversion target binary file retrieved from the second table 111b, 111b' of the database 111, and generate a text file containing the first to n^{th} operation characteristic data in the text data format.

In the present disclosure, the text file generated by the computer 130 may have an 'xls' extension, a 'cvs' extension, or a 'txt' extension. The specific method by which the computer 130 generates a text file when the text file has an 'xls' extension, a 'cvs' extension, or a 'txt' extension has already been described in detail.

After Step S160, the method according to the present disclosure may further include the step of, by the computer 130, transmitting the text file to the data server 120 through the network 140, and the step of, by the data server 120, storing the text file in the first storage medium 121 to be matched with the corresponding binary file.

In Step S160, the method according to the present disclosure may include the step of, by the computer 130, determining a rate at which the binary file is converted into a text file in real time, and the step of outputting the rate in a graphic user interface through the display 131 of the computer 130.

In addition, after Step S160, the method according to the present disclosure may further include the step of, by the computer 130, analyzing the first to n^{th} operation characteristic data in the text data format included in the text file to generate a change pattern with respect to time of the operation characteristic data selected from the voltage data and current data of the battery, the temperature data of the constant temperature chamber, and the SOC of the battery as a graph image, and outputting the graph image through the display 131 of the computer 130.

Preferably, the computer 130 may receive a cycler ID, at least one test channel, and the type of operation characteristic data for generating a graph image, designated from the tester, generate at least one graph image according to the designated conditions, and output the graph image through the display 131 of the computer 130.

According to an embodiment of the present disclosure, the binary files generated by a plurality of cyclers may be stored comprehensively in a data server, a relational database may be built using the data structure information of the binary files generated by each cycler based on the version of the binary file, and the conversion work for the binary file into a text file may be performed automatically using the database. Therefore, the time required to convert the binary file generated by the cycler into a text file may be shortened. In particular, in the present disclosure, it is possible to dramatically reduce the hassle of the file conversion work when performing mass cycling tests for the battery by operating a plurality of cyclers.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

## Claims

1. A system of converting a binary file generated in a battery cycler into a text file, comprising:
a database server in which a database including a first table containing a cycler ID and version information of a binary file generated by a battery cycler and a second table containing the cycler ID and data structure information of the binary file generated by the battery cycler is built;
a data server configured to receive a binary file containing a test result of a battery from the battery cycler and store the binary file in a first storage medium; and
a computer connected to the database server and the data server, wherein the computer includes a second storage medium and a processor,
wherein the processor is configured to:
determine a cycler ID which generated a conversion target binary file from the first table using file version information read from a header of the conversion target binary file as a query key, and
convert the conversion target binary file into a text file based on the data structure information read from the second table using the cycler ID as the query key and record the text file in the second storage medium.

2. The system of converting a binary file generated in a battery cycler into a text file according to claim 1,
wherein the processor is configured to output a binary file list on a display by searching the first storage medium, and allow at least one conversion target binary file to be selected from a tester.

3. The system of converting a binary file generated in a battery cycler into a text file according to claim 1,
wherein the battery cycler includes a plurality of test channels that perform a respective cycling test independently, and is configured to generate at least two binary files with different versions for each test channel, and
wherein the first table has a data structure in which one cycler ID and at least two version information match each other.

4. The system of converting a binary file generated in a battery cycler into a text file according to claim 3,
wherein the second table is built independently for each of the at least two binary files with different versions.

5. The system of converting a binary file generated in a battery cycler into a text file according to claim 1,
wherein the second table has a data structure in which information about type, name, and size of each of a plurality of data included in the data structure information is matched with a corresponding cycler ID each other.

6. The system of converting a binary file generated in a battery cycler into a text file according to claim 1,
wherein the test result includes first to n^{th} operation characteristic data regarding battery operation characteristics obtained periodically,
wherein the binary file includes a header structure containing the version information and first to n^{th} data structures in a binary data format corresponding to the first to n^{th} operation characteristic data, respectively, and
wherein the processor is configured to sequentially generate first to n^{th} operation characteristic data in a text data format while sequentially reading the first to n^{th} data structures from the conversion target binary file with reference to the data structure information of the conversion target binary file retrieved from the second table and generate a text file containing the first to n^{th} operation characteristic data in the text data format.

7. The system of converting a binary file generated in a battery cycler into a text file according to claim 6,
wherein the text file has an 'xls' extension, a 'cvs' extension or a 'txt' extension.

8. The system of converting a binary file generated in a battery cycler into a text file according to claim 6,
wherein a k^{th} data structure (k is a natural number from 1 to n) includes time data corresponding to an acquisition time of k^{th} operation characteristic data and a plurality of operation characteristic data selected from voltage data and current data of the battery, temperature data of a constant temperature chamber in the battery cycler, and SOC change amount data, and
wherein each of the time data and the plurality of operation characteristic data is included in the k^{th} data structure with a preset data size.

9. The system of converting a binary file generated in a battery cycler into a text file according to claim 1,
wherein the processor is configured to transmit the text file to the data server through a network, and
wherein the data server is configured to store the text file in the first storage medium to be matched with the conversion target binary file.

10. The system of converting a binary file generated in a battery cycler into a text file according to claim 1,
wherein the processor is configured to determine a conversion rate of the conversion target binary file to the text file in real time and output the conversion rate in a graphic user interface through a display.

11. The system of converting a binary file generated in a battery cycler into a text file according to claim 8,
wherein the processor is configured to analyze the first to n^{th} operation characteristic data in the text data format included in the text file to generate a time change pattern of the operation characteristic data selected from the voltage data and current data of the battery, the temperature data of the constant temperature chamber in the battery cycler, and the SOC change amount data as a graph image and output the graph image through a display.

12. A method of converting a binary file generated in a battery cycler into a text file, comprising:
(a) by a database server, building a database including a first table containing a cycler ID and version information of a binary file generated by a battery cycler and a second table containing the cycler ID and data structure information of the binary file generated by the battery cycler;
(b) by a data server, receiving a binary file containing a test result of a battery from the battery cycler through a network and storing the binary file in a first storage medium;
(c) by a computer, outputting a binary file list on a display by searching the first storage medium, and allowing at least one conversion target binary file to be selected from a tester;
(d) by the computer, identifying file version information included in a header of the conversion target binary file;
(e) by the computer, determining a cycler ID which generated the conversion target binary file from the first table using the version information of the binary file as a query key in association with the database server;
(f) by the computer, reading data structure information of the conversion target binary file from the second table using the cycler ID as the query key in association with the database server; and
(g) by the computer, converting the conversion target binary file into a text file based on the data structure information and recording the text file in a second storage medium.

13. The method of converting a binary file generated in a battery cycler into a text file according to claim 12,
wherein the battery cycler includes a plurality of test channels that perform a cycling test independently, and is configured to generate at least two binary files with different versions for each test channel, and
wherein the first table has a data structure in which one cycler ID and at least two version information match each other.

14. The method of converting a binary file generated in a battery cycler into a text file according to claim 13,
wherein in the step (a), the database server builds the second table independently for each version of the binary file.

15. The method of converting a binary file generated in a battery cycler into a text file according to claim 12,
wherein the second table has a data structure in which information about type, name, and size of each of a plurality of data included in the data structure information is matched with a corresponding cycler ID each other.

16. The method of converting a binary file generated in a battery cycler into a text file according to claim 12,
wherein the test result includes first to n^{th} operation characteristic data regarding battery operation characteristics obtained periodically,
wherein the binary file includes a header structure containing the version information and first to n^{th} data structures in a binary data format corresponding to the first to n^{th} operation characteristic data, respectively, and
wherein in the step (g), the computer sequentially generates first to n^{th} operation characteristic data in a text data format while sequentially reading the first to n^{th} data structures from the conversion target binary file with reference to the data structure information of the conversion target binary file retrieved from the second table, and generates a text file containing the first to n^{th} operation characteristic data in the text data format.

17. The method of converting a binary file generated in a battery cycler into a text file according to claim 16,
wherein the text file has an 'xls' extension, a 'cvs' extension or a 'txt' extension.

18. The method of converting a binary file generated in a battery cycler into a text file according to claim 16,
wherein a k^{th} data structure (k is a natural number from 1 to n) includes time data corresponding to an acquisition time of k^{th} operation characteristic data and a plurality of operation characteristic data selected from voltage data and current data of the battery, temperature data of a constant temperature chamber in a coupler, and SOC change amount data, and
wherein each of the time data and the plurality of operation characteristic data is included in the k^{th} data structure with a preset data size.

19. The method of converting a binary file generated in a battery cycler into a text file according to claim 12, further comprising:
by the computer, transmitting the text file to the data server; and
by the data server, storing the text file in the first storage medium to be matched with the corresponding conversion target binary file.

20. The method of converting a binary file generated in a battery cycler into a text file according to claim 12, further comprising:
by the computer, determining a conversion rate of the conversion target binary file to the text file in real time and outputting the conversion rate in a graphic user interface through the display.

21. The method of converting a binary file generated in a battery cycler into a text file according to claim 18, further comprising:
by the computer, analyzing the first to n^{th} operation characteristic data in the text data format included in the text file to generate a time change pattern of the operation characteristic data selected from the voltage data and current data of the battery, the temperature data of the constant temperature chamber in the battery cycler, and the SOC change amount data as a graph image and outputting the graph image through the display.
